# EUROPEAN PATENT APPLICATION

(11) **EP 0 821 394 A1**
(43) Date of publication of application: **28.01.1998**
(21) Application number: 97305371.3
(22) Date of filing: 18.07.1997
(51) Int. Cl.: H01J 37/305, C23C 14/24

(54) **Electron beam evaporator**

(30) Priority: 25.07.1996 US 686301
(71) Applicant: THE BOC GROUP, INC., Murray Hill, New Providence, New Jersey 07974-2082 (US)
(72) Inventor: Hill, Russell J., El Cerrito, California 94530 (US)
(74) Representative: Bousfield, Roger James

(57) **Abstract**

A rod feed mechanism for an electron beam evaporation source comprising a pusher arm for raising rod-like ingots in an upward direction into a position feeding a crucible of the electron beam evaporation source; a rotary magazine located below the electron beam evaporation source and having retaining means for retaining the rod-like ingots in an upright orientation, the retaining means having slots to allow travel of the pusher arm within the rotary magazine in the upward direction; means for rotating the rotary magazine to position each of the ingots in alignment with the crucible of the electron beam evaporation source; and means located along side of the rotary magazine for raising the pusher arm from a retracted position beneath the rotary magazine to an operating position above the retracted position and in contact with the rod-like ingots, thereby to raise the ingots into the position by the pusher arm and for lowering the pusher arm from the operating positions back to the retracted position to allow the rotary magazine to rotate.

## Description

This invention relates to electron beam evaporation processes and apparatus and, more particularly, to a rod feed mechanism for an electron beam evaporation source in which a rod-like ingot carried within a rotary magazine is fed by a pusher mechanism into a crucible of an electron beam evaporation source. More particularly, the invention relates to such a mechanism in which the pusher mechanism is located along side of the rotary magazine to reduce the height of the mechanism.

In physical vapour deposition by electron beam evaporation, an evaporant is evaporated within a crucible to produce a vapour cloud which acts as a transport media to deposit the evaporant on a substrate. In a rod-fed electron beam evaporation source, the evaporant is in the form of a rod-like ingot which is upwardly fed into a central opening provided within a crucible. The ingot is evaporated within the crucible by an electron beam deflected through an arc of 270°. The ingot and replacement ingots are contained within a rotating magazine located within a vacuum chamber in which the electron beam evaporation source operates. Before each ingot has been spent, the ingot is held in position while a replacement ingot from the rotary magazine is aligned with the ingot being held. An ingot pusher pushes the replacement ingot in an upward direction, against the held ingot, to continue to raise the ingot being evaporated and the replacement into the crucible. The ingot pusher is acted upon by a pusher plafform which is raised and lowered by a ball screw mechanism.

The ball screw mechanism is located beneath the rotary magazine and has a length that is about equal to the stroke required to push the replacement ingot and held ingot through the crucible. This of course adds to the height of the electron beam evaporation system. This is disadvantageous because such system is located within a clean-room environment in which the space is expensive and any reduction of spaced used by equipment is keenly sought. Another problem with pusher mechanisms of the prior art is that they use a linear feedthrough. Such feedthroughs are unreliable and are a constant source of leaks which can contaminate the vacuum within the vacuum chamber housing the electron beam evaporation source.

The invention is concerned with the provision of an improved rod-feed mechanism which generally takes up less space than prior art mechanisms and does not use linear feedthroughs.

In accordance with the invention, there is provided a rod feed mechanism for an electron beam evaporation source comprising a pusher arm for raising rod-like ingots in an upward direction into a position feeding a crucible of the electron beam evaporation source; a rotary magazine located below the electron beam evaporation source and having retaining means for retaining the rod-like ingots in an upright orientation, the retaining means having slots to allow travel of the pusher arm within the rotary magazine in the upward direction; means for rotating the rotary magazine to position each of the ingots in alignment with the crucible of the electron beam evaporation source; and means located along side of the rotary magazine for raising the pusher arm from a retracted position beneath the rotary magazine to an operating position above the retracted position and in contact with the rod-like ingots, thereby to raise the ingots into the position by the pusher arm and for lowering the pusher arm from the operating positions back to the retracted position to allow the rotary magazine to rotate.

The slots in the retaining means generally permit the pusher arm to enter the rotary magazine as well as to allow travel of the pusher arm within the rotary magazine.

For a better understanding of the invention, reference will now be made, by way of exemplification only, to the accompanying drawings, in which:
Figure 1 is an elevational view of a rod-feed mechanism in accordance with the invention in which portions of a carousel and a vacuum chamber have been broken away;
Figure 2 is a fragmentary, elevational view of Figure 1;
Figure 3 is a fragmentary sectional view taken along line 3-3 of Figure 1 ; and
Figure 4 is a fragmentary, sectional view of Figure 1 taken along line 4-4 of Figure 1.

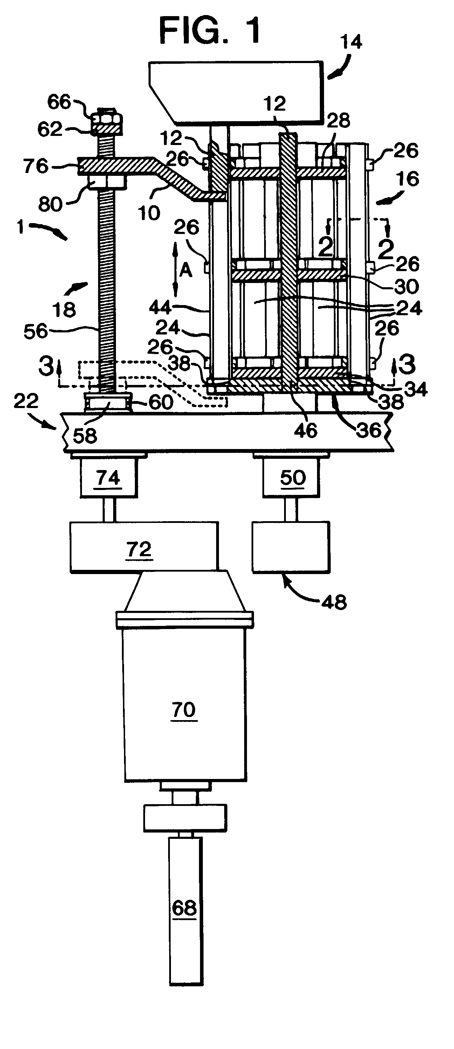

With reference to Figure 1 a rod-feed mechanism in accordance with the invention is illustrated. The rod-feed mechanism 1 is provided with a pusher arm 10 for raising rod-like ingots 12 in an upward direction into a position feeding a crucible contained within an electron beam evaporation source 14. The rod-like ingots are stored and then rotated by a rotating magazine into a position in which each rod-like ingot 12 is in alignment with the crucible of the electron beam evaporation source 14. When a rod-like ingot needs to be replaced, the pusher arm 10 is moved in a vertical direction, by way of a twin ball screw mechanism 18, from a retracted position 20 (illustrated by phantom lines) to an operating position (illustrated by solid lines). The ball screw mechanism 18 moves the pusher arm 10 from the operating position to the retracted position and back into operating positions in the direction of vertical double headed arrowhead A. In operation, the rod-feed apparatus 1 would be housed within a vacuum chamber having a wall 22.

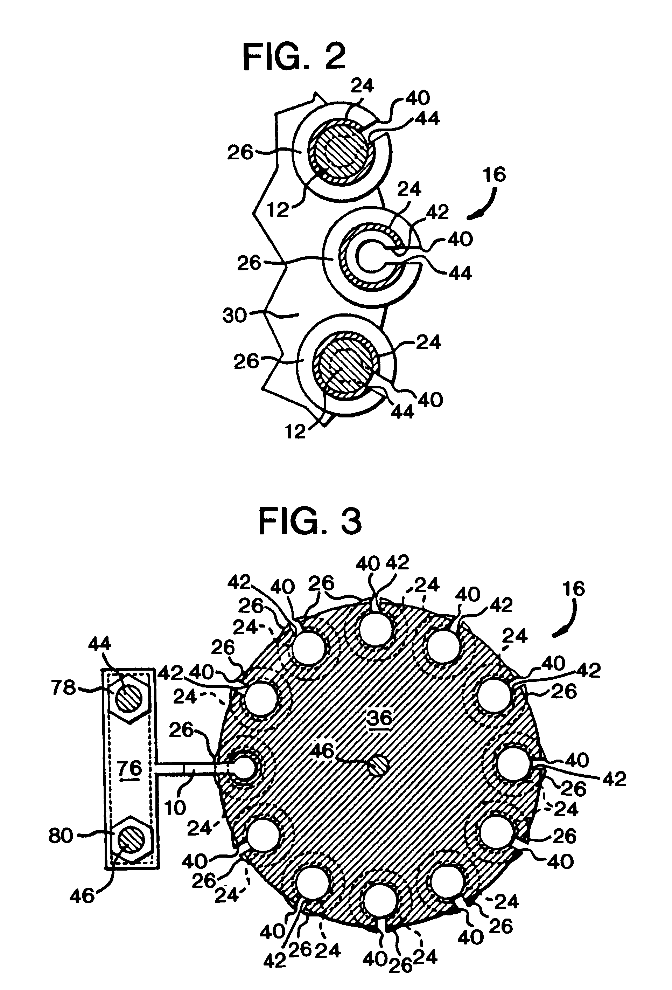

With additional reference to Figures 2 and 3, a rotary magazine 16 consists of a carousel-like arrangement of tubes 24 sized to retain rod-like ingots 12 in an upright position. The tubes 24 are welded to washer like retainers 26 which are in turn welded to a spaced arrangement of disc-like supports 28, 30 and 34. Bottom regions of the tubes 12 are connected to a disc-like magazine base 36 having circular recesses 38 to support the rod-like ingots 12. In order for the pusher arm 20 to move from its retracted to operating positions, the washer-like supports 26, the magazine base 36 and the tubes 24 are provided with slots 40, 42 and 44 respectively.

The rotary magazine 16 is driven through a central axle 46 by an indexing drive mechanism 48 operating through a rotary vacuum feedthrough 50. The central axle 46 passes through the magazine base 36 and the supports 28, 30 and 34.

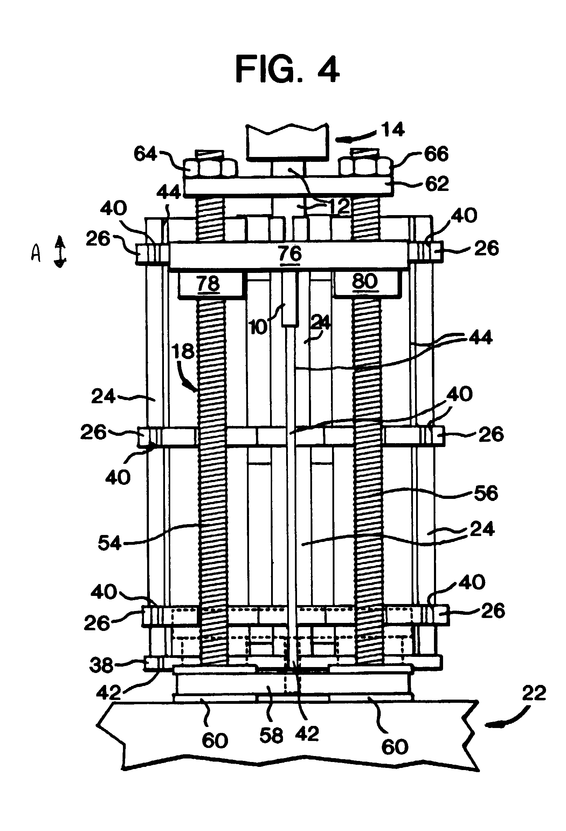

With reference to Figure 4, the pusher arm 10 is raised and lowered by a double ball screw-mechanism consisting of ball screws 54 and 56 joined at the bottom by a belt 58 driving sprockets 60 which are provided at the base of the ball screws 54 and 56. At the top, a top frame member 62 having ball nuts 64 and 66 is provided. The ball screw mechanism 18 is driven by low and high speed gear motors 68 and 70 engaged by an electro-clutch 72. The electro-clutch 72 is driven by a shaft of the high speed gear motor 70 to drive the ball screw 56 through a rotary vacuum feedthrough 74. The belt 58 is driven by the sprockets 60 and produces rotation of ball screw 54. A pusher plafform 76 having ball nuts 78 and 80 moves in the direction of double headed arrow A upon rotation of the ball screws 54 and 56. A pusher arm 10 is connected to pusher plafform 76 and thus moves pusher plafform 76 moves by rotation of ball screws 54 and 56.

In the drawings, the pusher arm 10 has moved from the retracted position, through the slot 42 of the magazine base 36 and the slots 26 of the lower two washer-like retainers and up the slot 44 of the operating tube 24 to bear against the base of an ingot 12 that is being fed to the electron beam evaporation source 14. Prior to the time that the ingot 12 has been spent and when the pusher arm 10 is above the rotary magazine 16, the pusher arm 10 reverses its direction of travel to return to the retracted position. It has been found that the portion of the ingot 12 that has not been evaporated will remain in position, above the rotary magazine 16. At this point, the rotary magazine is rotated by the motor 48 to position a fresh ingot 12 into a position aligned with the crucible of the electron beam evaporation source 14 and therefore, the nearly used up ingot 12 which has been left within the crucible of electron beam evaporation source 14. As described above, the pusher arm 10 moves from the retracted position back to the operating position. Initially the unused ingot 10 bears against the ingot 10 in use until such ingot has been fully melted. Thereafter, the fresh ingot 10 is evaporated.

## Claims

1. A rod feed mechanism for an electron beam evaporation source comprising:
a pusher arm for raising rod-like ingots in an upward direction into a position feeding a crucible of the electron beam evaporation source;
a rotary magazine located below the electron beam evaporation source and having retaining means for retaining the rod-like ingots in an upright orientation, the retaining means having slots to allow travel of the pusher arm within the rotary magazine in the upward direction;
means for rotating the rotary magazine to position each of the ingots in alignment with the crucible of the electron beam evaporation source; and
means located along side of the rotary magazine for raising the pusher arm from a retracted position beneath the rotary magazine to an operating position above the retracted position and in contact with the rod-like ingots, thereby to raise the ingots into the position by the pusher arm and for lowering the pusher arm from the operating positions back to the retracted position to allow the rotary magazine to rotate.

2. A rod-feed mechanism according to Claim 1 in which the retaining means include a rotating carousel-like arrangement having tubes to retain the rod-like ingots and the slots extending in lengthwise directions of the tubes to permit the pusher arm to raise the rod-like ingots in the tubes in the upward direction and into the position.

3. The rod-feed mechanism according to Claim 1 or Claim 2 in which the pusher arm is driven by a double ball screw mechanism having twin ball screws arranged in frame having a pusher plafform raising and lowering with rotation of the twin ball screws, the pusher arm connected to the pusher plafform.
